# EUROPEAN PATENT APPLICATION

(11) **EP 4 312 253 A1**
(43) Date of publication of application: **31.01.2024**
(21) Application number: 23188104.6
(22) Date of filing: 27.07.2023
(51) Int. Cl.: H01L 21/78

(54) **SEMICONDUCTOR DEVICE AND MANUFACTURING METHOD OF SEMICONDUCTOR DEVICE**

(30) Priority: 29.07.2022 JP 2022121809
(71) Applicant: Mitsuboshi Diamond Industrial Co., Ltd., Settsu, Osaka 566-0034 (JP)
(72) Inventor: UECHA, Masashi, Nisshin-shi, 470-0111 (JP); NAGUMO, Yuji, Nisshin-shi, 470-0111 (JP); OKUDA, Masaru, Nisshin-shi, 470-0111 (JP); NAGAYA, Masatake, Nisshin-shi, 470-0111 (JP); KITAICHI, Mitsuru, Settsu-city, 566-0034 (JP); MORI, Akira, Settsu-city, 566-0034 (JP); KIYAMA, Naoya, Settsu-city, 566-0034 (JP); TAKEDA, Masakazu, Settsu-city, 566-0034 (JP)
(74) Representative: TBK

(57) **Abstract**

A semiconductor device (10, 100) includes a semiconductor substrate (12) having a quadrangular shape when viewed from above and having a front surface (12a), a rear surface (12b) opposite to the front surface, and four side surfaces (12c) connecting the front surface and the rear surface. Each of the side surfaces has a step section (30) in which a plurality of protruding portions (30a) and a plurality of recessed portions (30b) alternately and repeatedly appear along a direction in which a peripheral edge of the front surface of the semiconductor substrate extends.

## Description

The present disclosure relates to a semiconductor device and a manufacturing method of a semiconductor device.

JP 2019-57579 A (hereinafter referred to as Patent Literature 1) discloses a semiconductor device including a semiconductor substrate having a front surface, a rear surface, and side surfaces connecting the front surface and the rear surface. On the side surfaces of the semiconductor substrate, a modified layer is provided along a direction in which a peripheral edge of the front surface of the semiconductor substrate extends. The modified layer is a layer of crystal defects in which crystals are modified by laser irradiation. In the semiconductor device, adhesion to a package resin is improved by the modified layer.

The present disclosure proposes a new technique capable of ensuring adhesion between a semiconductor device and a resin by a method different from that of Patent Literature 1.

A semiconductor device according to a first aspect of the present disclosure includes a semiconductor substrate that has a quadrangular shape when viewed from above and has a front surface, a rear surface opposite to the front surface, and four side surfaces connecting the front surface and the rear surface. Each of the side surfaces has a step section in which a plurality of protruding portions and a plurality of recessed portions alternately and repeatedly appear along a direction in which a peripheral edge of the front surface of the semiconductor substrate extends.

In the semiconductor device, the step section in which the protruding portions and the recessed portions are repeated along the direction in which the peripheral edge of the front surface of the semiconductor substrate extends is provided on each of the side surfaces of the semiconductor substrate. Thus, a surface area of the side surfaces increases, and for example, when the semiconductor device is sealed with a resin, the resin entering the step section functions as an anchor. Accordingly, peeling between the semiconductor device and the resin after sealing is restricted. As described above, in the semiconductor device described above, it is possible to ensure adhesion to the resin by the step section on each of the side surfaces of the semiconductor substrate.

A manufacturing method of a semiconductor device according to a second aspect of the present disclosure includes: preparing a semiconductor wafer having a hexagonal crystal structure and having a first surface on which a metal layer is disposed and a second surface opposite to the first surface; forming a plurality of cracks by pressing a pressing member against a front surface of the metal layer along a plurality of planned dividing lines that extends to divide the semiconductor wafer into a plurality of quadrangular regions, the plurality of cracks extending in a thickness direction of the semiconductor wafer along the plurality of planned dividing lines; and after the forming of the plurality of cracks, dividing the semiconductor wafer and the metal layer using the plurality of cracks as a plurality of starting points by pressing a dividing member against the second surface along the plurality of planned dividing lines. Each of the planned dividing lines extends in a direction different from a {11-20} plane and a {1-100} plane of the semiconductor wafer. In the present disclosure, the {11-20} plane means planes including all planes of (11-20), (-1-120), (1-210), (-12-10), (-2110), and (2-1-10), which are equivalent to each other due to crystal symmetry. In addition, the {1-100} plane in the present disclosure means planes including all planes of (1-100), (-1100), (0-110), (01-10), (10-10), and (-1010), which are equivalent to each other due to crystal symmetry.

In this manufacturing method, after the metal layer is formed on the first surface of the semiconductor wafer, the pressing member is pressed against the front surface of the metal layer from a direction facing the first surface along the planned dividing lines. By pressing the pressing member, the cracks are formed in a portion of the semiconductor wafer close to the first surface. Thereafter, the dividing member is pressed against the semiconductor wafer from a direction facing the second surface along the planned dividing lines. As a result, a force is applied in a direction in which adjacent regions are separated from each other across the cracks with the crack as the starting points. As a result, the cracks extend in the thickness direction of the semiconductor wafer. At this time, the semiconductor wafer is cleaved on crystal planes starting from the cracks, so that the semiconductor wafer is divided. In addition, a force is also applied to the metal layer in a direction of separating adjacent regions across the cracks, and the metal layer is also divided.

In the hexagonal crystal structure, the {11 -20} plane, which is one of the crystal planes, extends linearly without interruption over a plurality of crystal lattices. Therefore, if a planned dividing line extends along a direction that coincides with the {11-20} plane, when the pressing member is pressed against the semiconductor wafer, the crack is formed along the {11-20} plane. As described above, when the semiconductor wafer is divided, the semiconductor wafer is cleaved along the crystal plane starting from the crack. Therefore, when the dividing member is pressed against the semiconductor wafer along the planned dividing line that coincides with the {11-20} plane, the semiconductor wafer can be linearly divided along the {11-20} plane. In this case, at least one of the side surfaces (divided surfaces) of the divided semiconductor wafer becomes the {11-20} plane, and the divided surface becomes a smooth flat surface.

On the other hand, in the above-described manufacturing method, each of the planned dividing lines extends in the direction different from the {11-20} plane of the semiconductor wafer. Therefore, when the pressing member is pressed against the semiconductor wafer, the cracks are formed along directions different from the {11-20} plane. Therefore, when the semiconductor wafer is divided with the cracks as starting points, a step section having a plurality of protruding portions and a plurality of recessed portions is formed on each of the side surfaces of the divided semiconductor wafer, and the surface area of the side surfaces increases due to the formation of the step section.

As described above, in the above-described manufacturing method, since each of the cracks is formed along the direction different from the {11-20} plane, the step section is formed on each of the side surfaces of the divided semiconductor wafer. Therefore, for example, when the semiconductor device manufactured by this manufacturing method is sealed with a resin, the resin entering the step section functions as an anchor. Accordingly, peeling between the semiconductor device and the resin after sealing is restricted. As described above, in the semiconductor device manufactured by the above-described manufacturing method, since the step section is formed on each of the side surfaces, it is possible to secure adhesion to the resin.

In the above description, a case where the planned dividing line extends in a direction different from the {11-20} plane has been described as an example. However, also in a case where the planned dividing line extends in a direction different from the {1-100} plane, the step section is similarly formed on each of the side surfaces of the divided semiconductor wafer.

Additional objects and advantages of the present disclosure will be more readily apparent from the following detailed description when taken together with the accompanying drawings. In the drawings:
FIG. 1 is a side view of a semiconductor device according to a first embodiment;
FIG. 2 is a top view of the semiconductor device according to the first embodiment;
FIG. 3 is a diagram for explaining a crystal structure of silicon carbide (SiC);
FIG. 4 is a partially enlarged view of the vicinity of an intersecting side of two side surfaces in which a step section is formed by cleavage of a semiconductor substrate of the semiconductor device of the first embodiment;
FIG. 5 is a plan view of a semiconductor wafer;
FIG. 6 is a diagram for explaining a metal forming process of the first embodiment;
FIG. 7 is a diagram for explaining a crack forming process of the first embodiment;
FIG. 8 is a diagram for explaining a dividing process of the first embodiment;
FIG. 9 is a diagram for explaining directions in which planned dividing lines extend;
FIG. 10 is an optical microscope photograph showing a divided surface of a semiconductor wafer divided by the dividing process;
FIG. 11 is a diagram illustrating a plurality of divided semiconductor devices;
FIG. 12 is a bottom view of a semiconductor device according to a second embodiment;
FIG. 13 is a perspective view of a pressing member for manufacturing the semiconductor device according to the second embodiment; and
FIG. 14 is a diagram for explaining a crack forming process of the second embodiment.

In one example, in the semiconductor device according to the first aspect of the present disclosure, a metal layer may be disposed on the rear surface of the semiconductor substrate. The metal layer may have a plurality of notch portions arranged at intervals along an outer peripheral edge of the rear surface. In the notch portions, the rear surface may be exposed.

In such a configuration, the metal layer has the notch portions along the outer peripheral edge of the rear surface of the semiconductor substrate. Therefore, when the semiconductor device is sealed with a resin, the resin also enters the notch portions. Accordingly, the resin also functions as an anchor in the notch portions. Therefore, the adhesion between the semiconductor device and the resin can be further ensured.

In one example, in the semiconductor device according to the first aspect of the present disclosure, at least a part of each of the side surfaces may be a cleaved surface.

In one example, in the manufacturing method according to the second aspect, the forming of the plurality of cracks may include pressing the pressing member against the metal layer along the plurality of planned dividing lines to form a plurality of holes that is arranged at intervals in the metal layer along the planned dividing lines and reaches the first surface of the semiconductor wafer.

In such a configuration, when the pressing member is pressed against the semiconductor wafer along the planned dividing lines, the metal layer is divided along the holes arranged at intervals. Therefore, after the division, the first surface of the semiconductor wafer is exposed at intervals along the outer peripheral edge thereof. That is, a plurality of notch portions is provided at intervals along the outer peripheral edge of the divided metal layer. Therefore, when the semiconductor device manufactured by this manufacturing method is sealed with a resin, the resin also enters the notch portions. Accordingly, the resin also functions as an anchor in the notch portions. Therefore, the adhesion between the semiconductor device and the resin can be further ensured.

### (First Embodiment)

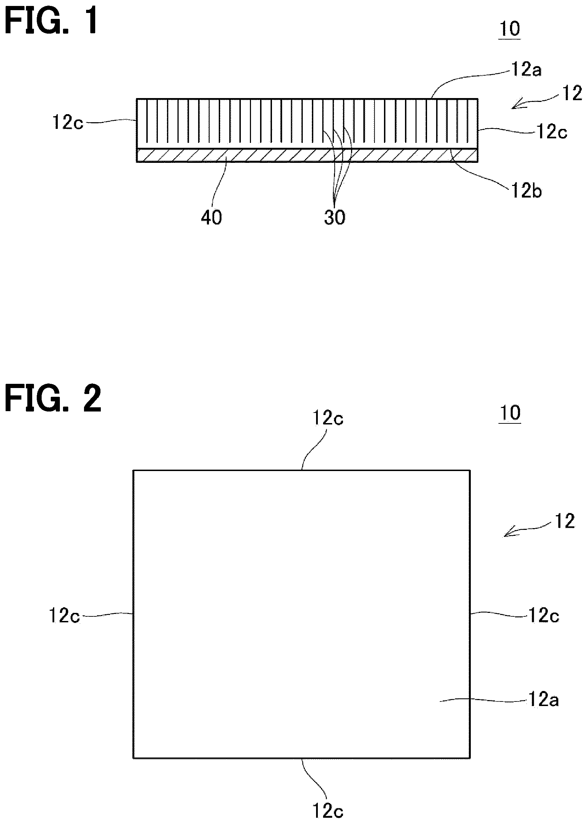

A semiconductor device 10 of a first embodiment will be described with reference to the drawings. As shown in FIG. 1, the semiconductor device 10 includes a semiconductor substrate 12 and a metal layer 40. The semiconductor substrate 12 has a front surface 12a, a rear surface 12b located opposite to the front surface 12a, and four side surfaces 12c connecting the front surface 12a and the rear surface 12b. As shown in FIG. 2, the semiconductor substrate 12 has a quadrangular shape when viewed from above. Although not illustrated, semiconductor elements having functions such as transistors and diodes are formed in the semiconductor substrate 12. The semiconductor substrate 12 is made of silicon carbide (SiC). Note that the semiconductor substrate 12 may be made of another semiconductor material such as gallium nitride (GaN).

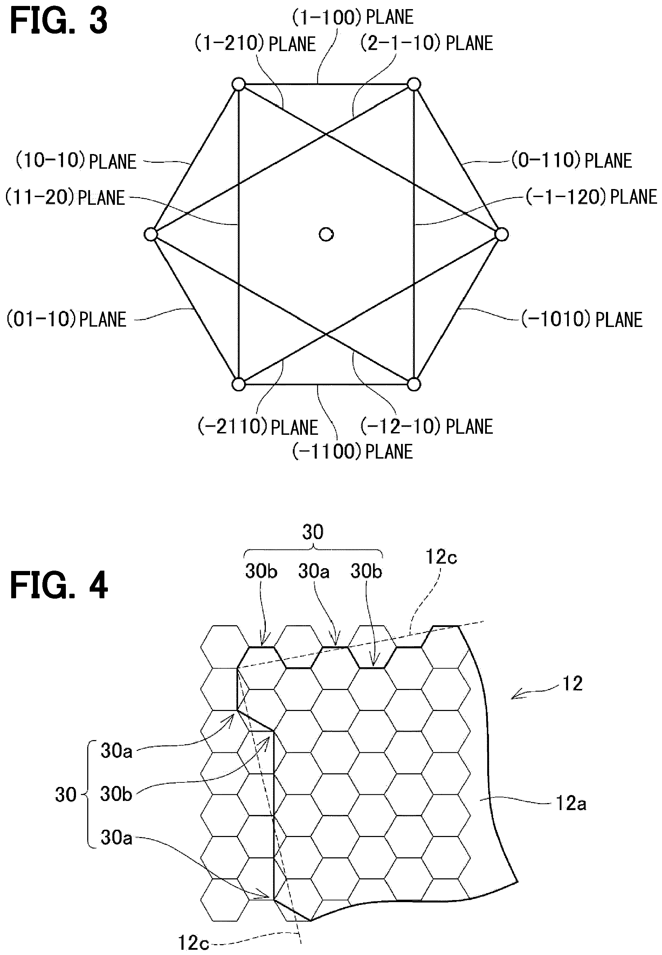

The semiconductor substrate 12 has a hexagonal crystal structure shown in FIG. 3. As shown in FIG. 3, the semiconductor substrate 12 has a plurality of crystal planes such as a (11-20) plane. Although not shown, a plane parallel to a plane of a paper on which FIG. 3 is illustrated is a (0001) plane. In the present embodiment, the front surface 12a of the semiconductor substrate 12 is a (0001) plane. As shown in FIG. 1 and FIG. 4, a step section 30 is formed on each of the side surfaces 12c of the semiconductor substrate 12. As shown in FIG. 4, the step section 30 has a plurality of protruding portions 30a and a plurality of recessed portions 30b that repeatedly appear along a direction in which a peripheral edge of the front surface 12a of the semiconductor substrate 12 extends (that is, a direction in which the side surfaces 12c extend when the semiconductor substrate 12 is viewed from above). The protruding portions 30a and the recessed portions 30b extend linearly along a thickness direction of the semiconductor substrate 12. Each of the side surfaces 12c of the semiconductor substrate 12 (indicated by an imaginary line in FIG. 4) is configured by the protruding portions 30a and the recessed portions 30b. Each surface constituting the protruding portions 30a and the recessed portions 30b coincides with any one of the crystal planes shown in FIG. 3. That is, each of the side surfaces 12c includes a plurality of crystal planes of the semiconductor substrate 12. As shown in FIG. 1, the step section 30 is formed in the thickness direction of the semiconductor substrate 12 from the front surface 12a of the semiconductor substrate 12 to a position that does not reach the rear surface 12b. A thickness of a portion of the semiconductor substrate 12 where the step section 30 is not formed is not particularly limited, but is, for example, about 10 µm.

As shown in FIG. 1, the metal layer 40 is provided on the rear surface 12b of the semiconductor substrate 12. A material constituting the metal layer 40 is not particularly limited. The metal layer 40 may be, for example, a multilayer film in which titanium, nickel, and gold are stacked. The metal layer 40 is provided over substantially the entire region of the rear surface 12b of the semiconductor substrate 12. The metal layer 40 functions as an electrode of the semiconductor device 10. Although not illustrated, an electrode may be provided on the front surface 12a of the semiconductor substrate 12.

The semiconductor device 10 of the present embodiment may be sealed with a resin in order to manufacture a semiconductor module, for example. In the semiconductor device 10 of the present embodiment, the step section 30 in which the protruding portions 30a and the recessed portions 30b are repeated along the direction in which the peripheral edge of the front surface 12a of the semiconductor substrate 12 extends is provided on each of the side surfaces 12c of the semiconductor substrate 12. Therefore, when the semiconductor device 10 is sealed with a resin, the resin enters the recessed portion 30b in the step section 30 to function as an anchor. Accordingly, peeling between the semiconductor device 10 and the resin after sealing is restricted. As described above, in the semiconductor device 10 of the present embodiment, the step section 30 of each of the side surfaces 12c of the semiconductor substrate 12 can ensure adhesion to the resin.

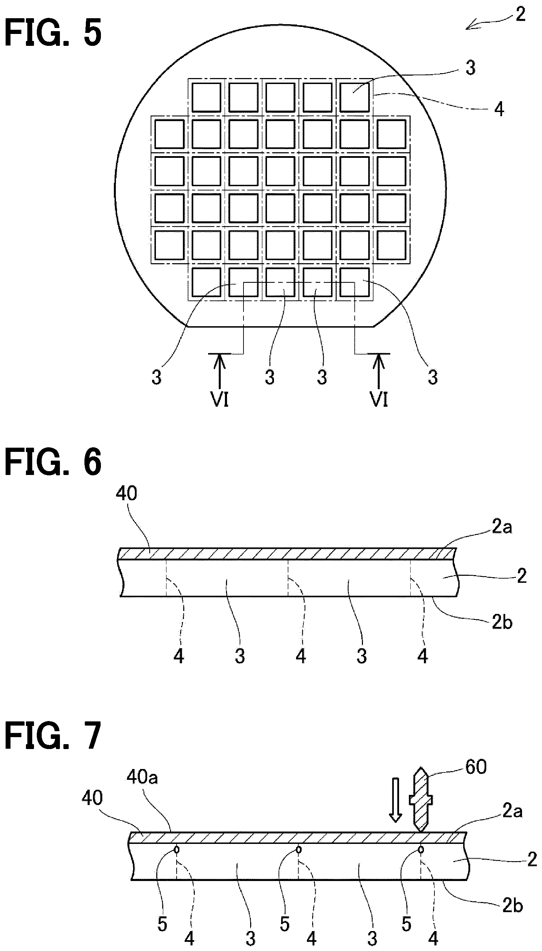

Next, a manufacturing method of the semiconductor device 10 will be described. First, a semiconductor wafer 2 shown in FIG. 5 is prepared. In the semiconductor wafer 2, a plurality of element regions 3 is formed in a matrix. In FIG. 5, each of the element regions 3 is schematically illustrated by a solid line. For convenience of description, division lines that are boundaries between adjacent element regions 3 and are used when the semiconductor wafer 2 is divided into individual element regions 3 are referred to as planned dividing lines 4. That is, the planned dividing lines 4 extend to divide the semiconductor wafer 2 into a plurality of quadrangular regions. The planned dividing lines 4 are not actually drawn on the semiconductor wafer 2 but are virtual lines. The planned dividing lines 4 may be lines or grooves actually drawn on the semiconductor wafer 2 so as to be visible. In each of the element regions 3, a semiconductor element having a function such as a transistor or a diode is formed. The semiconductor wafer 2 is made of silicon carbide (SiC). The semiconductor wafer 2 may be made of another semiconductor material such as gallium nitride (GaN). As shown in FIG. 6 and the like, the semiconductor wafer 2 has a first surface 2a and a second surface 2b located opposite to the first surface 2a. As will be described later, each of the planned dividing lines 4 extends in a direction different from a {11-20} plane of the semiconductor wafer 2.

### <Metal Layer Forming Process>

A metal layer forming process shown in FIG. 6 is performed on the semiconductor wafer 2 shown in FIG. 5. In the metal layer forming process, the metal layer 40 is formed on the first surface 2a of the semiconductor wafer 2. The metal layer 40 is a multilayer film in which titanium, nickel, and gold are stacked. The metal layer 40 is formed so as to cover substantially the entire region of the first surface 2a. That is, the metal layer 40 is formed on the first surface 2a so as to extend over the element regions 3. The metal layer 40 functions as an electrode of the completed semiconductor device.

### <Crack Forming Process>

Next, a crack forming process shown in FIG. 7 is performed. In the crack forming process, a scribing wheel 60 is pressed against a front surface 40a of the metal layer 40 from a direction facing the first surface 2a of the semiconductor wafer 2 to form scribe lines with cracks 5 in the semiconductor wafer 2. The scribing wheel 60 is a disk-shaped (annular) member and is rotatably supported by a support apparatus (not shown). The scribing wheel 60 is moved (scanned) along the planned dividing lines 4 while being pressed against the front surface 40a of the metal layer 40. When the scribing wheel 60 is moved along the planned dividing lines 4, the scribing wheel 60 rolls on the front surface 40a of the metal layer 40 like a tire rolling on a road surface. The scribing wheel 60 has a sharp peripheral edge, and forms the scribe lines in which the metal layer 40 is plastically deformed along the planned dividing lines 4 on the front surface 40a of the metal layer 40. When the front surface 40a is pressed by the scribing wheel 60, compressive stress is generated in a region of a surface layer of the first surface 2a inside the semiconductor wafer 2 through the metal layer 40. While the scribe lines (that is, the grooves) are formed at pressed portions by the scribing wheel 60, tensile stress is generated in the semiconductor wafer 2 immediately below the region where compressive stress is generated. The tensile stress is generated in a direction away from the planned dividing lines 4 along the first surface 2a of the semiconductor wafer 2 immediately below the region where the compressive stress is generated. Due to this tensile stress, the crack 5 extending in the thickness direction of the semiconductor wafer 2 is formed inside the semiconductor wafer 2. In the present embodiment, by moving the scribing wheel 60 along the planned dividing lines 4 while pressing the scribing wheel 60 against the front surface 40a, the cracks 5 are formed along the boundary between the adjacent element regions 3 so as to extend in the thickness direction of the semiconductor wafer 2. The cracks 5 are formed in the vicinity of the surface layer of the first surface 2a of the semiconductor wafer 2. The scribing wheel 60 is an example of a pressing member.

### <Dividing Process>

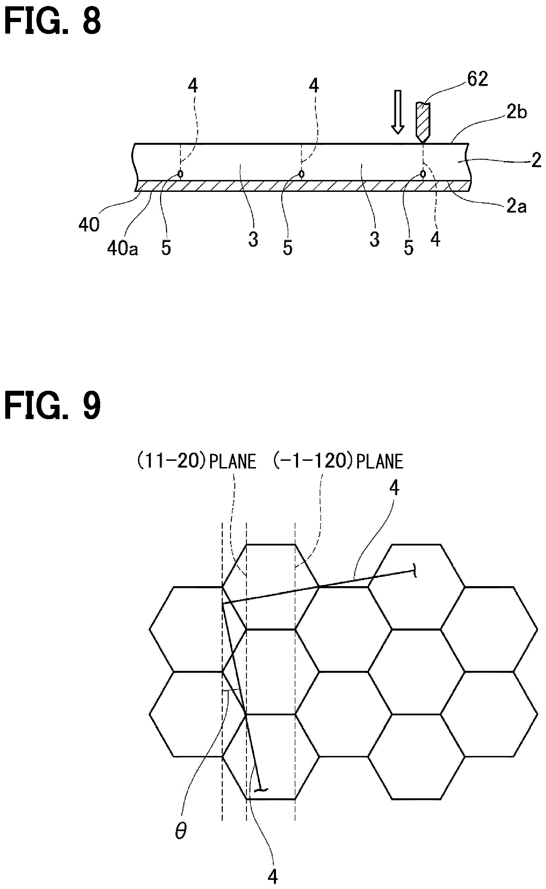

Next, a dividing process shown in FIG. 8 is performed. It should be noted that in FIG. 8, the semiconductor wafer 2 is illustrated in such a manner that the second surface 2b faces upward. In the dividing process, a breaking plate 62 is pressed along the planned dividing lines 4 (that is, the cracks 5 formed in the crack forming process), and the semiconductor wafer 2 is divided along the planned dividing lines 4 (that is, along the boundaries of the element regions 3). In the present embodiment, the breaking plate 62 is pressed against the second surface 2b of the sem iconductor wafer 2. The breaking plate 62 is a plate-like member. A lower end of the breaking plate 62 (that is, an end edge pressed against the second surface 2b) has a ridgeline shape (a sharp edge shape), but is only pressed against the semiconductor wafer 2 without cutting the semiconductor wafer 2.

When the breaking plate 62 is pressed against the second surface 2b, the semiconductor wafer 2 is bent. The cracks 5 are formed in the vicinity of the surface layer of the first surface 2a of the semiconductor wafer 2. Therefore, when the breaking plate 62 is pressed against the semiconductor wafer 2 from the direction facing the second surface 2b, the semiconductor wafer 2 is bent about the pressed portion (line), and, in a portion close to the first surface 2a, a force is applied to the crack 5 in a direction in which the crack 5 is spread and the two element regions 3 adjacent to the crack 5 is separated. As described above, the tensile stress is applied to the periphery of the crack 5. Therefore, when the breaking plate 62 is pressed against the second surface 2b, the crack 5 extends in the thickness direction of the semiconductor wafer 2, and the semiconductor wafer 2 is cleaved along the crystal plane from the crack 5 as a starting point. As a result, the semiconductor wafer 2 is divided. That is, divided surfaces (the side surfaces 12c shown in FIG. 1 and the like) of the semiconductor wafer 2 are cleaved surfaces. In addition, since the metal layer 40 is formed on the first surface 2a of the semiconductor wafer 2, a force is also applied to the metal layer 40 in a direction in which the two element regions 3 adjacent to the dividing position are separated, and the metal layer 40 is deformed to be separated and is divided along the planned dividing lines 4. The breaking plate 62 is an example of a "dividing member".

In the present embodiment, the semiconductor wafer 2 has a hexagonal crystal structure. As shown in FIG. 9, in the hexagonal crystal structure, a {11-20} plane which is one of the crystal planes (in FIG. 9, a (11-20) plane and a (-1-120) plane are illustrated) extends linearly without interruption over a plurality of crystal lattices. Therefore, if the planned dividing line 4 extends along a direction coinciding with the {11-20} plane, when the scribing wheel 60 is pressed against the semiconductor wafer 2, the crack 5 is formed along the {11-20} plane. As described above, when the semiconductor wafer 2 is divided, the semiconductor wafer 2 is cleaved along the crystal plane starting from the crack 5. Therefore, when the breaking plate 62 is pressed against the semiconductor wafer 2 along the planned dividing line 4 coinciding with the {11-20} plane, the semiconductor wafer 2 can be linearly divided along the {11-20} plane. In this case, at least one of the side surfaces (divided surfaces) of the semiconductor wafer 2 after division becomes the {11-20} plane, and the divided surface becomes a smooth flat surface.

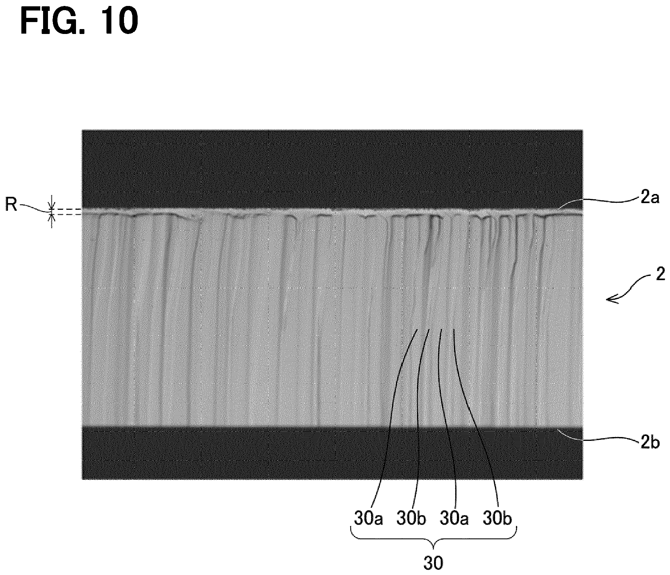

On the other hand, in the manufacturing method of the present embodiment, as shown in FIG. 9, the planned dividing line 4 extends in a direction different from the {11-20} plane of the semiconductor wafer 2 (that is, a direction inclined from the {11-20} plane by an angle θ). Therefore, when the scribing wheel 60 is pressed against the semiconductor wafer 2, the crack 5 is formed along the direction different from the {11-20} plane (that is, along the planned dividing line 4). Therefore, when the semiconductor wafer 2 is divided from the crack 5 as the starting point, the semiconductor wafer 2 is cleaved in a zigzag manner so that a plurality of crystal planes are exposed. As a result, a step section having a plurality of protruding portions and a plurality of recessed portions formed by a plurality of crystal planes (the step section 30 shown in FIG. 4) is formed on the side surfaces (divided surfaces) of the semiconductor wafer 2 after division. FIG. 10 is an optical microscope photograph showing the divided surface of the semiconductor wafer 2 divided by the dividing process described above. As shown in FIG. 10, it can be seen that the step section 30 in which the protruding portions 30a and the recessed portions 30b repeatedly appear is formed along a horizontal direction of FIG. 10.

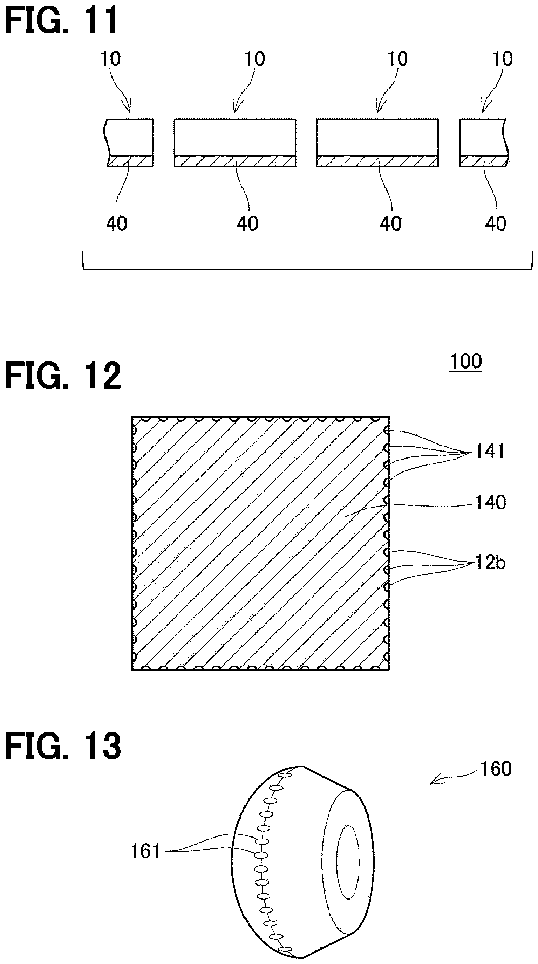

In the dividing process, the process of pressing the breaking plate 62 against the second surface 2b is repeatedly performed along each of the planned dividing lines 4. Accordingly, the semiconductor wafer 2 and the metal layer 40 can be divided along the boundaries between the element regions 3. As a result, as shown in FIG. 11, the semiconductor wafer 2 is divided into a plurality of semiconductor devices 10. Thus, the semiconductor devices 10 having the metal layers 40 (electrodes) are completed. In FIG. 11, illustration of the step section 30 is omitted.

As described above, in the manufacturing method of the present embodiment, since the cracks 5 are formed along the directions different from the {11-20} plane, the step section 30 is formed on each of the side surfaces of the divided semiconductor wafer 2. Therefore, for example, when the semiconductor device 10 manufactured by this manufacturing method is sealed with a resin, the resin entering the step section 30 functions as an anchor. Accordingly, peeling between the semiconductor device 10 and the resin after sealing is restricted. As described above, in the semiconductor device 10 manufactured by the manufacturing method of the present embodiment, since the step section 30 is formed on each of the side surfaces 12c, it is possible to secure adhesion to the resin.

In the manufacturing method of the present embodiment, the cracks 5 are formed along the planned dividing lines 4. Therefore, when the semiconductor wafer 2 is divided in the dividing process, as shown in FIG. 10, the step section 30 is not formed in a range R in which the cracks 5 are formed, and the range R is a substantially flat surface. However, since the depth of the range R is extremely small with respect to the entire thickness of the semiconductor wafer 2, the adhesion to the resin is hardly affected in the semiconductor device 10 to be manufactured.

### (Second Embodiment)

A semiconductor device 100 of a second embodiment includes a metal layer 140 instead of the metal layer 40 in the first embodiment. In the first embodiment, the metal layer 40 is disposed on substantially the entire region of the rear surface 12b of the semiconductor substrate 12. In the present embodiment, as shown in FIG. 12, the metal layer 140 has a plurality of notch portions 141 arranged at predetermined intervals along an outer peripheral edge of the rear surface 12b of the semiconductor substrate 12. The rear surface 12b of the semiconductor substrate 12 is exposed in each of the notch portions 141.

In the present embodiment, the metal layer 140 has the notch portions 141 along the outer peripheral edge of the rear surface 12b of the semiconductor substrate 12. Therefore, when the semiconductor device 100 is sealed with the resin, the resin also enters the notch portion 141. Accordingly, the resin also functions as an anchor in the notch portions 141. Therefore, the adhesion between the semiconductor device 100 and the resin can be further ensured.

Next, a manufacturing method of the semiconductor device 100 of the second embodiment will be described. In the manufacturing method of the second embodiment, a crack forming process is different from that of the first embodiment. The other processes such as the metal layer forming process and the dividing process are similar to those in the first embodiment.

In the second embodiment, a scribing wheel 160 shown in FIG. 13 is used. The scribing wheel 160 is different from the scribing wheel 60 of the first embodiment in configuration of a peripheral edge portion. The peripheral edge portion of the scribing wheel 160 has a corrugated shape when viewed from a rotation axis direction of the scribing wheel 160. That is, the peripheral edge portion has a plurality of grooves 161 along a circumferential direction of the scribing wheel 160, and ridge lines constituting the outer periphery of the scribing wheel 160 are intermittently present.

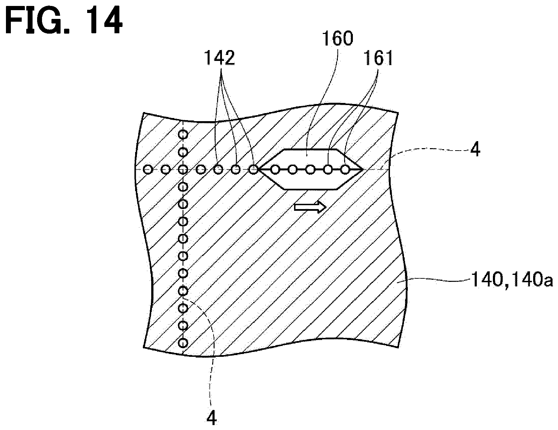

In the present embodiment, as shown in FIG. 14, the scribing wheel 160 is pressed against a front surface 140a of the metal layer 140 to form the cracks 5 in the semiconductor wafer 2. Since the peripheral edge portion of the scribing wheel 160 has the corrugated shape with the grooves 161, when the scribing wheel 160 is moved (rolled) along the planned dividing lines 4 with a constant load, a region in which the pressing force to the metal layer 140 is large and a region in which the pressing force is small repeatedly appear at predetermined intervals along the planned dividing lines 4. As a result, the cracks 5 are formed along the planned dividing lines 4 in the semiconductor wafer 2, while holes 142 arranged at intervals along the planned dividing lines 4 are formed in the metal layer 140 in a manner corresponding to the ridge lines intermittently present on the outer periphery of the scribing wheel 160. In this process, the scribing wheel 160 is rolled with a load with which the holes 142 reaching from the front surface 140a of the metal layer 140 to the first surface 2a of the semiconductor wafer 2 are formed. That is, in this process, the first surface 2a of the semiconductor wafer 2 is exposed at a bottom of each of the holes 142. Thereafter, as in the first embodiment, the semiconductor wafer 2 is divided into a plurality of semiconductor devices 100 by performing the dividing process.

In the second embodiment, when the cracks 5 are formed in the semiconductor wafer 2, the holes 142 arranged at intervals along the planned dividing lines 4 are simultaneously formed in the metal layer 140. Therefore, when the breaking plate 62 is pressed against the semiconductor wafer 2 along the planned dividing lines 4, the metal layer 140 is divided along the holes 142 arranged at intervals. Therefore, after the division, the first surface 2a of the semiconductor wafer 2 is exposed at intervals along the outer peripheral edge thereof. That is, in the metal layer 140 after the division, the notch portions 141 are provided at intervals along the outer peripheral edge of the metal layer 140. Therefore, in the semiconductor device 100 manufactured by the manufacturing method of the present embodiment, when the semiconductor device is sealed with a resin, the resin also enters the notch portions. Accordingly, the resin also functions as an anchor in the notch portions. Therefore, the adhesion between the semiconductor device 100 and the resin can be further ensured.

In the first embodiment and the second embodiment, cases where each of the planned dividing lines 4 extends in the direction different from the {11-20} plane has been described as examples. However, also in a case where each of the planned dividing lines 4 extends in a direction different from the {1-100} plane, the step section 30 is similarly formed on each of the side surfaces 12c of the divided semiconductor substrate 12.

It should be noted that if the crystal orientation is to be indicated, a bar (-) should originally be attached above the desired number, but since there are restrictions on the representation based on the electronic application, the bar is attached before the desired number in the present specification and the drawings.

Although the embodiments have been described in detail above, these are merely examples and do not limit the scope of claims. The techniques described in the claims include various modifications and modifications of the specific examples illustrated above. The technical elements described in the present specification or the drawings exhibit technical usefulness alone or in various combinations, and are not limited to the combinations described in the claims at the time of filing. In addition, the techniques illustrated in the present specification or drawings achieve a plurality of objectives at the same time, and achieving one of the objectives itself has technical usefulness.

A semiconductor device (10, 100) includes a semiconductor substrate (12) having a quadrangular shape when viewed from above and having a front surface (12a), a rear surface (12b) opposite to the front surface, and four side surfaces (12c) connecting the front surface and the rear surface. Each of the side surfaces has a step section (30) in which a plurality of protruding portions (30a) and a plurality of recessed portions (30b) alternately and repeatedly appear along a direction in which a peripheral edge of the front surface of the semiconductor substrate extends.

## Claims

1. A semiconductor device (10, 100) comprising:
a semiconductor substrate (12) having a quadrangular shape when viewed from above and having a front surface (12a), a rear surface (12b) opposite to the front surface, and four side surfaces (12c) connecting the front surface and the rear surface, wherein
each of the side surfaces has a step section (30) in which a plurality of protruding portions (30a) and a plurality of recessed portions (30b) alternately and repeatedly appear along a direction in which a peripheral edge of the front surface of the semiconductor substrate extends.

2. The semiconductor device (100) according to claim 1, further comprising
a metal layer (140) disposed on the rear surface of the semiconductor substrate, wherein
the metal layer has a plurality of notch portions (141) arranged at intervals along an outer peripheral edge of the rear surface, and
the rear surface is exposed in the plurality of notch portions.

3. The semiconductor device according to claim 1 or 2, wherein
at least a part of each of the side surfaces is a cleaved surface.

4. A manufacturing method of a semiconductor device, comprising:
preparing a semiconductor wafer (2) having a hexagonal crystal structure and having a first surface (2a) on which a metal layer (40, 140) is disposed and a second surface (2b) opposite to the first surface;
forming a plurality of cracks (5) by pressing a pressing member (60, 160) against a front surface (40a, 140a) of the metal layer along a plurality of planned dividing lines that extends to divide the semiconductor wafer into a plurality of quadrangular regions, the plurality of cracks extending in a thickness direction of the semiconductor wafer along the plurality of planned dividing lines; and
after the forming of the plurality of cracks, dividing the semiconductor wafer and the metal layer using the plurality of cracks as a plurality of starting points by pressing a dividing member (62) against the second surface of the semiconductor wafer along the plurality of planned dividing lines, wherein
each of the plurality of planned dividing lines extends in a direction different from a {11-20} plane and a {1-100} plane of the semiconductor wafer.

5. The manufacturing method according to claim 4, wherein
the forming of the plurality of cracks includes forming a plurality of holes (142) by pressing the pressing member (160) against the metal layer (140) along the plurality of planned dividing lines, and
the plurality of holes (142) is arranged at intervals in the metal layer along the planned dividing lines and reaches the first surface of the semiconductor wafer.
